(19)

Europäisches
Patentamt
European
Patent Office
Office européen
des brevets

(11) **EP 1 900 849 B1**

(12) **EUROPEAN PATENT SPECIFICATION**

(45) Date of publication and mention
of the grant of the patent:
**13.05.2009 Bulletin 2009/20**

(51) Int Cl.:
**C23C 30/00** *(2006.01)*     **C22C 29/08** *(2006.01)*
**B22F 7/00** *(2006.01)*

(21) Application number: **07114549.4**

(22) Date of filing: **17.08.2007**

(54) **Cemented carbide inserts for milling of hard Fe-based alloys >45 HRC**

Zementierte Karbideinsätze zum Fräsen harter Eisenlegierungen > 45 HRC

Insertions de carbure métallique pour le fraisage d'alliages à base de Fe de roche à dureté HRC > 45

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **28.08.2006 SE 0601759**

(43) Date of publication of application:
**19.03.2008 Bulletin 2008/12**

(73) Proprietor: **Sandvik Intellectual Property AB
811 81 Sandviken (SE)**

(72) Inventors:
• **Norgren, Susanne
SE-141 41, Huddinge (SE)**
• **Westergren, Kenneth
SE-129 35, Hägersten (SE)**

(74) Representative: **Hägglöf, Henrik
Sandvik Intellectual Property AB
811 81 Sandviken (SE)**

(56) References cited:
**EP-A- 1 757 388          EP-A- 1 795 628
EP-A- 1 798 308          US-A1- 2005 129 986**

Printed by Jouve, 75001 PARIS (FR)

**Description**

The present invention relates to a coated cutting tool insert particularly useful for milling of hard cast irons and hardened steels. A thin PVD-coating greatly improves the flank wear resistance and the notch wear resistance combined with a substrate that provides good resistance against plastic deformation, comb cracks and edge line chipping.

Milling of hard cast irons and hardened steels can generally be divided in roughing, semi-roughing, semi-finishing and finishing. In milling hardened steel, hard steels, tool steels and cast irons edge line chipping and notch wear is one of the dominant wear mechanisms.

It is an object of the present invention to provide a cutting tool insert particularly useful for milling hard cast irons, hard steels, tool steels and hardened steels.

It is a further object of the present invention to provide a cutting tool insert with improved edge line security, wear resistance in combination with good plastic deformation resistance.

It has now surprisingly been found that a hard cubic carbide containing cemented carbide substrate combined with a relatively thin PVD-coating in combination with a special edge treatment giving a sharp edge greatly improves the edge line security, wear resistance in addition to good resistance against plastic deformation resulting in increased tool life and surface quality on the workpiece surfaces when milling in hardened steels and hard cast irons with hardness >45 HRC.

The substrate comprises a cemented carbide with a hardness of 1700 HV3-2000 HV3, preferably with the composition 5.4-6.3 wt-% Co, preferably 5.7-6.1 wt-% Co, 0.7-1.0 wt-% Ta+Nb, preferably 0.6-0.95 wt-% Ta+Nb, most preferably 0.7-0.9 wt-% Ta+Nb, and 5.0-7.0 wt-% Ti, preferably 5.5-6.5 wt-% Ti, most preferably 6.0-6.4 wt-% Ti, added as TaC, NbC and TiC or mixtures of these, and balance WC with as sintered Hc-value of 20-26, preferably 21-25, kA/m.

The cobalt binder phase is alloyed with W giving the invented cemented carbide cutting insert its desired properties. W in the binder phase influences the magnetic properties of cobalt and can hence be related to a value, CW-ratio, defined as

$$CW\text{-}ratio = \text{magnetic-\% Co} \; / \; \text{wt-\% Co}$$

where magnetic-% Co is the weight percentage of magnetic Co and wt-% Co is the weight percentage of Co in the cemented carbide.

The CW-ratio varies between 1 and about 0.75 dependent on the degree of W-alloying. Lower CW-ratios correspond to higher W and CW=1 corresponds practically to an absence of W in the binder phase. The cemented carbide body according to the invention has a CW-ratio 0.75-0.95, preferably 0.78-0.90.

The uncoated substrates have a 10° angle and 0.2 mm wide negative chamfer giving an edge sharpness of 0 (sharp)-40 $\mu$m.

The coating comprises a homogeneous $Al_xTi_{1-x}N$-layer with x=0.6-0.67, preferably x=0.62. Such coatings are known for example from the US patent application US 2005/0129986 A1. The total thickness of the layer is >1 $\mu$m, preferably >1.8 $\mu$m, but <3.8 $\mu$m, preferably <3.0 $\mu$m. Both the composition and the thickness are determined on the flank face 1 mm from the nose radius and 200 $\mu$m from the cutting edge.

The present invention also relates to a method of making a coated cutting tool insert consisting of a cemented carbide substrate and a coating. The cemented carbide substrate has before coating a 10° angle and 0.2 mm wide negative chamfer giving an edge sharpness of 0(sharp)-40 $\mu$m and is made using conventional powder metallurgical techniques milling, pressing and sintering.

The substrate comprises a cemented carbide with a hardness of 1700 HV3-2000 HV3, preferably with the composition 5.4-6.3 wt-% Co, preferably 5.7-6.1 wt-% Co, 0.7-1.0 wt-% Ta+Nb, preferably 0.6-0.95 wt-% Ta+Nb, most preferably 0.7-0.9 wt-% Ta+Nb, and 5.0-7.0 wt-% Ti, preferably 5.5-6.5 wt-% Ti, most preferably 6.0-6.4 wt-% Ti, added as TaC, NbC and TiC or mixtures of these, and balance WC with as sintered Hc-value of 20-26, preferably 21-25 kA/m.

After conventional post sintering treatment a coating comprising $Al_xTi_{1-x}N$ with x=0.6-0.67, preferably x=0.62 is deposited by cathodic arc evaporation using a target material consisting of TiAl-alloy of suitable composition, in an $N_2$ gas atmosphere. The total thickness of the coating is >1 $\mu$m, preferably >1.8 $\mu$m, but <3.8 $\mu$m, preferably <3.0 $\mu$m.

The present invention also relates to the use of the insert according to above for milling in hard steels, tool steels, hardened steels and hard cast irons with hardness >45 HRC at a cutting speed of 50-180 m/min and a feed of 0.1-0.4 mm/rev.

Example 1

A. Cemented carbide milling inserts in accordance with the invention with the composition 5.90 wt-% Co, 0.56 wt-% Ta, 0.35 wt-% Nb, 6.16 wt-% Ti added as TaC, NbC and TiC and balance WC with as sintered Hc-value of 23 kA/m and with a binder phase alloyed with W corresponding to a CW-ratio of 0.86 were coated with a 2.9 $\mu$m homogeneous $Al_{0.62}Ti_{0.38}N$-PVD-layer by cathodic arc evaporation using a target material consisting of a $Ti_{33}Al_{67}$-alloy. The arc evaporation was performed in an $N_2$ gas atmosphere.

B. (Reference) Commercial cemented carbide milling inserts with the composition of 3.70 wt-% Co, 1.43 wt-% Ta, 0.42 wt-% Nb and balance WC and with an Hc-value of 23 kA/m and a CW-ratio of 0.9. The inserts were coated with a 2.9 $\mu$m (Ti,Al)N PVD-coating as in A.

Example 2

Inserts from A and B were tested in turning of a cast steel.

| Operation: | Side long edge milling |
| --- | --- |
| Work-piece: | Stator and rotator segment |
| Material: | Austenitic steel with carbides, C=1.15 Hardness 55-58 HRC |
| Cutting speed: | 125 m/min (n=500) |
| Feed rate: | 700 mm/min (fz=0.28) |
| Depth of cut: | Radial $A_e$ =1-2 mm; axial Ap=50-70 mm |
| Insert-style: | SECT120612 T02010 |
| Note: | Dry milling |
| Criteria for replacing inserts: edge line chipping and/or risk of insert breakage. | |
| Results: | |
| Grade A: (invention) | 21 segments |
| Grade B: (prior art) | 15 segments |

Example 3

Inserts from A and B were tested in milling of a cast steel.

| Operation: | Side long edge milling |
| --- | --- |
| Work-piece: | Stator and rotator segment |
| Material: | Austenitic tool steel Hardness 60 HRC |
| Cutting speed: | 85 m/min (n=340) |
| Feed rate: | 320 mm/min (fz=0.19) |
| Depth of cut: | Radial $A_e$=1-2 mm; axial $A_p$=50-70 mm |
| Insert-style: | SECT120612 T02010 |
| Note: | Dry milling |
| Criteria for replacing inserts: edge line chipping and/or risk of insert breakage. | |
| Results: | |
| Grade A: (invention) | 8 segments (HIP) |
| Grade B: (prior art) | 2 segments (H05) |

**Claims**

1. Cutting tool insert for milling of hardened,steels, tool steels and hard cast irons and stainless steels comprising a substrate and a coating **characterized in that**
said substrate has a hardness of .1700 HV3-2000 HV3, with a 10° angle and 0.2 mm wide negative chamfer giving an edge sharpness of 0 (shark) -40 $\mu$m and
**in that** said coating comprises a homogeneous $Al_xTi_{1-x}N$-layer with x=0.6-0.67, preferably x=0.62, and has a total thickness of >1 $\mu$m, preferably >1.8 $\mu$m, but <3.8 $\mu$m, preferably <3.0 $\mu$m.

2. Cutting tool insert according to claim 1
**characterized in** the substrate having a composition 5.4-6-.3 wt-%-Co, preferable 5.7-6.1 wt-% Co, 0.7-1.0 w-t-%.

Ta+Nb, preferably 0.6-0.95 wt-% Ta+Nb, most preferably 0.7-0.9.wt-% Ta+Nb, and 5.0-7.0 wt-% Ti, preferably 5.5-6.5 wt-% Ti, most preferably 6.0-6.4 wt-% Ti, added as TaC, NbC and TiC or mixtures of these, and balance WC with as sintered Hc-value of 20-26, preferably 21-25, kA/m and CW 0.75-0.95, preferably 0.78-0.90.

3. Method of making a cutting tool insert consisting of a cemented carbide substrate and a coating whereby the substrate is-made using conventional powder metallurgical techniques milling, pressing and sintering **characterized in that** said substrate has a hardness of .1700 HV3-2000 HV3, with a 10° angle and 0.2 mm wide negative chamfer giving an edge sharpness of 0(sharp)-40 $\mu$m and

**in that** the coating comprising $Al_xTi_{1-x}N$ with x=0.6-0.67, preferably x=0.62 is deposited by cathodic arc evaporation using a target material consisting of TiAl-alloy of suitable composition; in an $N_2$ gas atmosphere whereby the total thickness of the coating is >1 $\mu$m, preferably >1.8 $\mu$m, but <3.8 $\mu$m, preferably <3.0 $\mu$m.

4. Method according claim 3 **characterized in that** in the substrate having a composition 5.4-6.3 wt-% Co, preferably 5.7-6.1 wt-% Co, 0.7-1.0.wt-% Ta+Nb, preferably 0.6-0.95 wt-% Ta+Nb, most preferably 0.7-0.9 wt-% Ta+Nb, and 5.0-7.0 wt-% Ti, preferably 5.5-6.5 wt-% Ti, most preferably 6.0-6.4 wt-% Ti, added as TaC, NbC and TiC or mixtures of these, and balance WC with as sintered Hc-value of 20-26, preferably 21-25, kA/m and a CW of 0.75-0.95, preferably 0.78-0.90.

5. Use of the insert according to claim 1 or 2 for milling in hardened steels >45 HRC and hard cast irons at a cutting speed of 30-180 m/min and a feed of. 0.1-0.4 mm/rev.

## Patentansprüche

1. Schneidwerkzeugeinsatz zum Fräsen von gehärteten Stählen, Werkzeugstählen und harten Gußeisen und nichtrostenden Stählen, der ein Substrat und eine Beschichtung aufweist, **dadurch gekennzeichnet, daß** das Substrat eine Härte von 1700 HV3 - 2000 HV3 hat, mit einem Winkel von 10° und einer 0,2 mm breiten negativen Anfasung, was eine Kantenschärfe von 0 (scharf) - 40 $\mu$m ergibt, und die Beschichtung eine homogene $Al_xTi_{1-x}N$-Schicht aufweist, wobei x = 0,6 - 0,67 ist und vorzugsweise x = 0,62 ist, und eine Gesamtdicke von > 1 $\mu$m, bevorzugt > 1,8 $\mu$m, jedoch < 3,8 $\mu$m, bevorzugt < 3,0 $\mu$m, hat.

2. Schneidwerkzeugeinsatz nach Anspruch 1, **dadurch gekennzeichnet, daß** das Substrat eine Zusammensetzung mit 5,4 - 6,3 Gew.-% Co, bevorzugt 5,7 - 6,1 Gew.-% Co, 0,7 - 1,0 Gew.-% Ta + Nb, bevorzugt 0,6 - 0,95 Gew.-% Ta + Nb, am meisten bevorzugt 0,7 - 0,9 Gew.-% Ta + Nb, und 5,0 - 7,0 Gew.-% Ti, bevorzugt 5,5 - 6,5 Gew.-% Ti, am meisten bevorzugt 6,0 - 6,4 Gew.-% Ti, zugegeben als TaC, NbC und TiC oder Gemische von diesen, und Rest WC hat, mit einem Hc-Wert von 20-26, bevorzugt 21-25, kA/m und einem CW von 0,75 - 0,95, bevorzugt 0,78 - 0,90, im gesinterten Zustand.

3. Verfahren zum Herstellen eines Schneidwerkzeugeinsatzes, bestehend aus einem Hartmetallsubstrat und einer Beschichtung, wobei das Substrat unter Verwendung herkömmlicher pulvermetallurgischer Techniken, wie Fräsen, Pressen und Sintern, hergestellt wird, **dadurch gekennzeichnet, daß** das Substrat eine Härte von 1700 HV3 - 2000 HV3 hat, mit einem Winkel von 10° und einer 0,2 mm breiten negativen Anfasung, was eine Kantenschärfe von 0 (scharf) - 40 $\mu$m ergibt, und die Beschichtung, die $Al_xTi_{1-x}N$, wobei x = 0,6 - 0,67, bevorzugt x = 0,62 ist, enthält, mittels Kathodenbogenverdampfung unter Verwendung eines Target-Materials, bestehend aus einer TiAl-Legierung mit einer geeigneten Zusammensetzung, in einer $N_2$-Gas-Atmosphäre abgeschieden wird, wobei die Gesamtdicke der Beschichtung > 1 $\mu$m, bevorzugt > 1,8 $\mu$m, jedoch < 3,8 $\mu$m, bevorzugt < 3,0 $\mu$m, ist.

4. Verfahren nach Anspruch 3, **dadurch gekennzeichnet, daß** in dem Substrat mit einer Zusammensetzung mit 5,4 - 6,3 Gew.-% Co, bevorzugt 5,7 - 6,1 Gew.-% Co., 0,7 - 1,0 Gew.-% Ta + Nb, bevorzugt 0,6 - 0,95 Gew.-% Ta + Nb, am meisten bevorzugt 0,7 - 0,9 Gew.-% Ta + Nb, und 5,0 - 7,0 Gew.-% Ti, bevorzugt 5,5 - 6,5 Gew.-% Ti, am meisten bevorzugt 6,0 - 6,4 Gew.-% Ti, zugegeben als TaC, NbC und TiC oder Gemische von diesen, und Rest WC hat, mit einem Hc-Wert von 20-26, bevorzugt 21-25, kA/m und einem CW von 0,75 - 0,95, bevorzugt 0,78 - 0,90, im gesinterten Zustand.

5. Verwendung des Einsatzes nach Anspruch 1 oder 2 zum Fräsen in gehärteten Stählen > 45 HRC und harten Gußeisen bei einer Schneidgeschwindigkeit von 30 - 180 m/Min. und einem Vorschub von 0,1 - 0,4 mm/U.

**Revendications**

1. Insert pour outil de coupe pour le fraisage d'aciers trempés, d'aciers pour outil et de fers pour fonte dure et d'aciers inoxydables comprenant un substrat et un revêtement, **caractérisée en ce que**
ledit substrat présente une dureté de 1 700 HV3 à 2 000 HV3, avec un angle de 10° et un chanfrein négatif d'une largeur de 0,2 mm donnant un coupant de bord de 0 (coupant) à 40 $\mu$m et
**en ce que** ledit revêtement comprend une couche de $Al_xTi_{1-x}N$ homogène avec x = 0,6 à 0,67, de préférence x = 0,62, et présente une épaisseur totale > 1 $\mu$m, de préférence > 1,8 $\mu$m, mais < 3,8 $\mu$m, de préférence < 3,0 $\mu$m.

2. Insert pour outil de coupe selon la revendication 1, **caractérisée en ce que** le substrat présente une composition de 5,4 à 6,3 % en poids de Co, de préférence de 5,7 à 6,1 % en poids de Co, 0,7 à 1,0 % en poids de Ta + Nb, de préférence de 0,6 à 0,95 % en poids de Ta + Nb, de manière préférée entre toutes de 0,7 à 0,9 % en poids de Ta + Nb, et de 5,0 à 7,0 % en poids de Ti, de préférence de 5,5 à 6,5 % en poids de Ti, de manière préférée entre toutes de 6,0 à 6,4 % en poids de Ti, ajouté sous la forme de TaC, NbC et TiC ou de leurs mélanges, et le reste étant constitué de WC avec une valeur Hc, fritté, de 20 à 26, de préférence de 21 à 25 kA/m et de CW de 0,75 à 0,95, de préférence de 0,78 à 0,90.

3. Procédé de fabrication d'un insert pour outil de coupe constitué d'un substrat en carbure cémenté et d'un revêtement, le substrat étant fabriqué en utilisant un fraisage, un pressage et un frittage issus de techniques classiques de métallurgie des poudres, **caractérisé en ce que** ledit substrat présente une dureté de 1 700 HV3 à 2 000 HV3, avec un angle de 10° et un chanfrein négatif d'une largeur de 0,2 mm donnant un coupant de bord de 0 (coupant) à 40 $\mu$m et
**en ce que** le revêtement comprenant du $Al_xTi_{1-x}N$ avec x = 0,6 à 0,67, de préférence x = 0,62, est déposé par évaporation par arc cathodique en utilisant un matériau cible constitué d'un alliage de TiAl d'une composition appropriée, dans une atmosphère de $N_2$ gazeux, l'épaisseur totale du revêtement étant > 1 $\mu$m, de préférence > 1,8 $\mu$m, mais < 3,8 $\mu$m, de préférence < 3,0 $\mu$m.

4. Procédé selon la revendication 3, **caractérisé en ce que** le substrat présente une composition de 5,4 à 6,3 % en poids de Co, de préférence de 5,7 à 6,1 % en poids de Co, 0,7 à 1,0 % en poids de Ta + Nb, de préférence de 0,6 à 0,95 % en poids de Ta + Nb, de manière préférée entre toutes de 0,7 à 0,9 % en poids de Ta + Nb, et de 5,0 à 7,0 % en poids de Ti, de préférence de 5,5 à 6,5 % en poids de Ti, de manière préférée entre toutes de 6,0 à 6,4 % en poids de Ti, ajouté sous la forme de TaC, NbC et TiC ou de leurs mélanges, et le reste étant constitué de WC avec une valeur Hc, fritté, de 20 à 26, de préférence de 21 à 25 kA/m et de CW de 0,75 à 0,95, de préférence de 0,78 à 0,90.

5. Utilisation de l'insert selon la revendication 1 ou 2 pour le fraisage d'aciers trempés > 45 HRC et de fers pour fonte dure à une vitesse de coupe de 30 à 180 m/min et une alimentation de 0,1 à 0,4 mm/tr.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050129986 A1